# EUROPEAN PATENT APPLICATION

(11) **EP 4 403 675 A1**
(43) Date of publication of application: **24.07.2024**
(21) Application number: 22926113.6
(22) Date of filing: 23.12.2022
(51) Int. Cl.: C25D 5/26, B21B 1/22, C21D 1/18, C21D 9/00, C21D 9/46, C22C 19/03, C22C 19/05, C22C 38/00, C22C 38/06, C22C 38/60, C23C 2/04, C23C 14/00, C25D 3/12, C25D 3/56, C25D 5/50

(54) **STEEL SHEET FOR HOT PRESSING, HOT-PRESSED MEMBER AND METHOD FOR PRODUCING HOT-PRESSED MEMBER**

(30) Priority: 08.02.2022 JP 2022018307
(71) Applicant: JFE Steel Corporation, Tokyo 100-0011 (JP)
(72) Inventor: SATO, Rinta, Tokyo 100-0011 (JP); MAKIMIZU, Yoichi, Tokyo 100-0011 (JP)
(74) Representative: Haseltine Lake Kempner LLP
(86) International application number: PCT/JP2022/047778
(87) International publication number: WO 2023/153099

(57) **Abstract**

For a steel sheet for hot pressing having a coating layer to prevent scale formation, adhesion of metals to heating equipment is reduced, liquid metal embrittlement cracking during hot press forming is prevented, and excellent post-painting corrosion resistance is achieved. A coated steel sheet for hot pressing includes: a base steel sheet; and a coating layer of 7 µm to 20 µm in thickness provided on both sides of the base steel sheet, wherein the coating layer is made of Ni or a Ni-based alloy, and a Zn content in the coating layer is 0 mass% to 10 mass%.

## Description

### TECHNICAL FIELD

The present disclosure relates to a steel sheet for hot pressing, a hot-pressed member, and a hot-pressed member production method.

### BACKGROUND

In the recent automotive field, high strength steel sheets are used as materials for parts in order to meet the conflicting demands of improving automotive body strength and reducing weight, and the strength required of high strength steel sheets is increasing year by year.

However, improving the strength of a steel sheet typically causes a decrease in press formability, and thus makes it difficult to obtain a complex part shape. Examples of automotive parts with complex shapes include suspension parts such as chassis and structural framework parts such as B-pillars.

Against this background, the use of hot pressing technology, which performs hot forming rather than cold forming, is increasing. Hot pressing is a forming method in which a steel sheet is heated to an austenite temperature range, then press-formed at high temperature, and simultaneously quenched by contact with a mold. In hot pressing, press forming is performed in a state in which the strength of the steel sheet as a material is relatively low, and the strength is increased by subsequent quenching. It is thus possible to achieve high strength and also ensure press formability.

However, hot pressing has a problem in that, since the steel sheet is heated to high temperature as mentioned above, the surface of the steel sheet oxidizes and scale forms. If scale exists on the surface of the steel sheet, oxides derived from the scale adhere to heating equipment. The heating is typically performed using a heating furnace. In such a case, oxides adhere to the inner wall of the heating furnace, conveyance rollers provided in the furnace, and the like. This requires maintenance of the heating equipment, causing a decrease in productivity. Moreover, if scale exists on the surface of the steel sheet, sufficient painting layer adhesion cannot be obtained in the subsequent painting process. It is thus necessary to remove scale by shot blasting or the like after hot pressing.

In view of this, steel sheets having, on their surfaces, a coating such as an Al or Al alloy coating layer, a Zn or Zn alloy coating layer, or an Al-Zn alloy coating layer are widely used as steel sheets for hot pressing (see, for example, JP 2000-038640 A (PTL 1) and JP 2003-073774 A (PTL 2)). The presence of such a coating layer can suppress oxidation of the surface of the base steel sheet during hot pressing and prevent scale formation.

### CITATION LIST

### Patent Literature

PTL 1: JP 2000-038640 A
PTL 2: JP 2003-073774 A

### SUMMARY

### (Technical Problem)

As mentioned above, by using a steel sheet for hot pressing having a coating layer on its surface, it is possible to suppress oxidation of the surface of the base steel sheet during hot pressing and prevent scale formation.

The foregoing conventional steel sheets for hot pressing, however, have the following problems.

One problem is adhesion of coating metal to heating equipment. In detail, in hot pressing, the steel sheet is heated to an austenite temperature range. Due to such heating, metal contained in the coating layer melts or evaporates and adheres to the heating equipment, for example, the inner wall of the heating furnace or rollers provided in the furnace. If the coating metal adheres to the heating equipment, maintenance of the heating equipment is required and consequently productivity decreases, as with the foregoing scale. Moreover, if the metal adheres to the rollers, the adhered metal reacts with the material of the rollers, causing embrittlement. This may lead to serious accidents such as damage to the rollers.

Another problem is liquid metal embrittlement cracking. Liquid metal embrittlement (LME) is a phenomenon in which, when tensile stress is applied in a state in which liquid metal is in contact with the surface of solid metal, the solid metal becomes brittle. In hot pressing, when press forming is performed in a state in which metal contained in the coating layer is melted due to heating, liquid metal embrittlement cracking occurs at the bent part that is subjected to tensile stress.

Thus, the conventional steel sheets for hot pressing including a coating layer have problems of adhesion of metal to heating equipment and liquid metal embrittlement cracking.

Furthermore, a hot-pressed member obtained by hot pressing a steel sheet for hot pressing is typically painted before use. Hence, the hot-pressed member eventually produced from the steel sheet for hot pressing is required to have excellent post-painting corrosion resistance.

It could therefore be helpful to provide a steel sheet for hot pressing and a hot-pressed member that can satisfy the following requirements (1) to (3):
(1) Reduction of adhesion of oxides and metals to heating equipment
(2) No liquid metal embrittlement cracking during hot press forming
(3) Excellent post-painting corrosion resistance.

### (Solution to Problem)

We thus provide the following.
1. A steel sheet for hot pressing, comprising: a base steel sheet; and a coating layer of 7 µm to 20 µm in thickness provided on both sides of the base steel sheet, wherein the coating layer is made of Ni or a Ni-based alloy, and a Zn content in the coating layer is 0 mass% to 10 mass%.
2. The steel sheet for hot pressing according to 1., wherein the coating layer contains at least one selected from the group consisting of Ti, V, Cr, Mn, Fe, Co, Mo, and W in a total amount of 50 mass% or less.
3. A hot-pressed member comprising: a base steel sheet; and a coating layer of 7 µm to 20 µm in thickness provided on both sides of the base steel sheet, wherein the coating layer is made of Ni or a Ni-based alloy, and a Zn content in the coating layer is 0 mass% to 10 mass%.
4. The hot-pressed member according to 3., further comprising an oxide layer of 10 µm or less in thickness on the coating layer.
5. The hot-pressed member according to 4., wherein a fraction of Ni in metal elements in the oxide layer is 50 at% or more.
6. A hot-pressed member production method comprising hot pressing the steel sheet for hot pressing according to 1. or 2. to obtain a hot-pressed member.

### (Advantageous Effect)

Since the steel sheet for hot pressing according to the present disclosure includes a coating layer on its surface, scale formation during hot pressing can be prevented to reduce adhesion of oxides to heating equipment. Moreover, as a result of the coating layer being made of Ni or a Ni-based alloy and having a Zn concentration of 10 % or less, adhesion of molten metal to heating equipment can be reduced and liquid metal embrittlement cracking during hot press forming can be prevented. Furthermore, a hot-pressed member obtained by hot pressing the steel sheet for hot pressing according to the present disclosure has excellent post-painting corrosion resistance.

### DETAILED DESCRIPTION

Embodiments of the present disclosure will be described in detail below. The present disclosure is, however, not limited to such embodiments. The unit of content "%" in the chemical compositions of the coating layer and steel sheet represents "mass%" unless otherwise specified.

### [Steel sheet for hot pressing]

A steel sheet for hot pressing in one embodiment of the present disclosure includes: a base steel sheet; and a coating layer of 7 µm to 20 µm in thickness provided on both sides of the base steel sheet. The coating layer is made of Ni or a Ni-based alloy, and the Zn concentration in the coating layer is 0 % to 10 %.

### [[Coating layer]]

The coating layer may be a coating layer made of Ni (Ni coating layer) or a coating layer made of a Ni-based alloy (Ni-based alloy coating layer). As used herein, "Ni-based alloy" refers to an alloy having a Ni content of 50 % or more. In other words, the coating layer according to the present disclosure is a coating layer having a Ni content of 50 % or more.

In the heating process prior to hot pressing, the surface layer of a steel sheet is oxidized by oxygen or water vapor in the atmosphere, as mentioned above. The steel sheet for hot pressing according to the present disclosure, however, includes a Ni-based coating layer with a high melting point and oxidation resistance on its surface, so that oxidation of the base steel sheet can be suppressed to prevent scale formation.

From the viewpoint of enhancing this effect, the Ni content in the coating layer is preferably 60 % or more, more preferably 70 % or more, and further preferably 80 % or more. The upper limit of the Ni content in the coating layer is not limited, and may be 100 %.

### Zn: 0 % to 10 %

If the coating layer contains a large amount of Zn, oxidation resistance decreases. In addition, Zn melts due to heating, and liquid metal embrittlement cracking occurs during hot forming. The Zn content in the coating layer is therefore 10 % or less. From the viewpoint of preventing liquid metal embrittlement cracking, the Zn content is preferably 5 % or less and more preferably 1 % or less. Since a lower Zn content is more preferable, the lower limit of the Zn content is 0 %.

The coating layer may optionally contain at least one selected from the group consisting of Ti, V, Cr, Mn, Fe, Co, Mo, and W in a total amount of 50 % or less. Adding at least one of Ti, V, Cr, Mn, Co, Mo, and W contributes to higher oxidation resistance. In the case where the coating layer is formed by electroplating, Fe eluted from the base steel sheet into the plating bath may be incorporated into the coating layer. If the content of these elements is excessive, the Ni content in the coating layer decreases relatively, so that the function of the coating layer is impaired. The total content of these elements is therefore 50 % or less, preferably 40 % or less, and more preferably 35 % or less. The lower limit of the total content is not limited, and may be 0 %.

The Fe content in the coating layer is preferably 20 % or less, more preferably 5 % or less, and further preferably 1 % or less. The lower limit of the Fe content may be 0 %.

The coating layer in one embodiment of the present disclosure has a chemical composition containing, in mass%, Zn: 0 % to 10 %, and at least one selected from the group consisting of Ti, V, Cr, Mn, Fe, Co, Mo, and W: 0 % to 50 % in total, with the balance consisting of Ni and inevitable impurities.

### Thickness: 7 µm to 20 µm

When the steel sheet for hot pressing is heated, Ni in the coating layer and Fe in the base steel sheet interdiffuse and a Ni-based alloy layer with an increased Fe concentration forms in the surface layer of the hot-pressed member. If the thickness of the coating layer in the steel sheet for hot pressing is less than 7 µm, particularly in the case where the steel sheet for hot pressing is heated at high temperature for a long time, Fe that has diffused and reached the surface layer is oxidized and a thick and brittle Fe-containing oxide layer forms. When such a thick and brittle Fe-containing oxide exists, the oxide adheres to and accumulates on the conveyance rollers and press die during the hot pressing process. This requires maintenance of the equipment, causing a decrease in productivity. Moreover, the oxide that has accumulated on the conveyance rollers and press die adheres to the surface of the hot-pressed member, thus impairing the surface quality of the hot-pressed member. From the viewpoint of inhibiting the growth of Fe oxide, that is, from the viewpoint of the scale guard function, the thickness of the coating layer is 7 µm or more. Given that higher corrosion resistance is achieved when the coating layer remaining after heating is thicker, the thickness of the coating layer is preferably 8 µm or more and more preferably 9 µm or more. If the thickness of the coating layer is more than 20 µm, the oxidation resistance effect and the corrosion resistance improving effect are saturated and the production cost only increases. The thickness of the coating layer is therefore 20 µm or less, preferably 16 µm or less, and more preferably 12 µm or less.

Herein, the thickness of the coating layer is defined as the thickness per one side of the steel sheet. The steel sheet for hot pressing according to the present disclosure has the coating layer on both sides. The thickness of the coating layer on one side may be the same as or different from the thickness of the coating layer on the other side.

### [[Base steel sheet]]

The base steel sheet is not limited, and any steel sheet may be used. The base steel sheet may be any of a hot-rolled steel sheet and a cold-rolled steel sheet.

From the viewpoint of obtaining a hot-pressed member with a tensile strength exceeding 980 MPa class after hot pressing, the base steel sheet preferably has a chemical composition containing, in mass%, C: 0.05 % to 0.50 %, Si: 0.1 % to 0.5 %, Mn: 0.5 % to 3.0 %, P: 0.1 % or less, S: 0.01 % or less, Al: 0.10 % or less, and N: 0.01 % or less with the balance consisting of Fe and inevitable impurities. The reasons why this chemical composition is preferable are as follows.

### C: 0.05 % to 0.50 %

C improves strength by forming martensite and the like as steel microstructure. In order to obtain a strength exceeding 980 MPa class, the C content needs to be 0.05 % or more. The C content is therefore preferably 0.05 % or more, and more preferably 0.10 % or more. If the C content is more than 0.50 %, the toughness of the spot weld decreases. The C content is therefore preferably 0.50 % or less. The C content is more preferably 0.45 % or less, further preferably 0.43 % or less, and most preferably 0.40 % or less.

### Si: 0.1 % to 0.5 %

Si is an effective element for strengthening steel and obtaining good material properties. In order to achieve this effect, the Si content needs to be 0.1 % or more. The Si content is therefore preferably 0.1 % or more, and more preferably 0.2 % or more. If the Si content is more than 0.5 %, ferrite is stabilized and as a result quench hardenability decreases. The Si content is therefore preferably 0.5 % or less. The Si content is more preferably 0.4 % or less, and further preferably 0.3 % or less.

### Mn: 0.5 % to 3.0 %

Mn is an effective element for ensuring strength after cooling over a wide cooling rate range. In order to ensure excellent mechanical properties, especially strength, it is desirable that the Mn content is 0.5 % or more. The Mn content is therefore preferably 0.5 % or more, more preferably 0.7 % or more, and further preferably 1.0 % or more. If the Mn content is more than 3.0 %, not only the cost increases but also the effect is saturated. The Mn content is therefore preferably 3.0 % or less. The Mn content is more preferably 2.5 % or less, further preferably 2.0 % or less, and most preferably 1.5 % or less.

### P: 0.1 % or less

If the P content is more than 0.1 %, due to grain boundary embrittlement caused by P segregation to austenite grain boundaries during casting, local ductility degrades and thus the balance between strength and ductility decreases. The P content is therefore preferably 0.1 % or less. The lower limit of the P content is not limited, and may be 0 %. From the viewpoint of the refining cost, however, the P content is preferably 0.002 % or more.

### S: 0.01 % or less

S forms inclusions such as MnS and causes degradation in impact resistance and cracking along the metal flow of the weld. It is thus desirable to reduce the S content as much as possible. The S content is preferably 0.01 % or less. From the viewpoint of ensuring good stretch flangeability, the S content is more preferably 0.005 % or less and further preferably 0.001 % or less. The lower limit of the S content is not limited, and may be 0 %. From the viewpoint of the refining cost, however, the S content is preferably 0.0002 % or more.

### Al: 0.10 % or less

If the Al content is more than 0.1 %, the blanking workability and quench hardenability of the steel sheet as a material decrease. The Al content is therefore preferably 0.10 % or less. The Al content is more preferably 0.07 % or less, and further preferably 0.04 % or less. The lower limit of the Al content is not limited, and may be 0 %. From the viewpoint of ensuring the effect as a deoxidizing material, however, the Al content is preferably 0.01 % or more.

### N: 0.01 % or less

If the N content is more than 0.01 %, AlN nitride forms during hot rolling or during heating before hot pressing, and the blanking workability and quench hardenability of the steel sheet as a material decrease. The N content is therefore preferably 0.01 % or less. The lower limit of the N content is not limited, and may be 0 %. From the viewpoint of the refining cost, however, the N content is preferably 0.001 % or more.

The chemical composition of the base steel sheet may optionally further contain at least one selected from the group consisting of Nb: 0.10 % or less, Ti: 0.05 % or less, B: 0.0002 % to 0.005 %, Cr: 0.1 % to 1.0 %, and Sb: 0.003 % to 0.03 %, for further property improvement.

### Nb: 0.10 % or less

Nb is an effective component for strengthening steel. If the Nb content is excessive, however, the rolling load increases. Accordingly, in the case where Nb is contained, the Nb content is 0.10 % or less, preferably 0.06 % or less, and more preferably 0.03 % or less. The lower limit of the Nb content is not limited, and may be 0 %. From the viewpoint of the refining cost, however, the Nb content is preferably 0.005 % or more.

### Ti: 0.05 % or less

Ti is effective for strengthening steel, as with Nb. If the Ti content is excessive, however, shape fixability decreases. Accordingly, in the case where Ti is contained, the Ti content is 0.05 % or less, and preferably 0.03 % or less. The lower limit of the Ti content is not limited, and may be 0 %. From the viewpoint of the refining cost, however, the Ti content is preferably 0.003 % or more.

### B: 0.0002 % to 0.005 %

B is an element that has the effect of inhibiting the formation and growth of ferrite from austenite grain boundaries. In order to achieve this effect, in the case where B is contained, the B content is preferably 0.0002 % or more and more preferably 0.0010 % or more. If the B content is excessive, formability is significantly impaired. Accordingly, in the case where B is contained, the B content is 0.005 % or less, and preferably 0.003 % or less.

### Cr: 0.1 % to 1.0 %

Cr is an element that strengthens steel and improves quench hardenability, as with Mn. In order to achieve this effect, in the case where Cr is contained, the Cr content is 0.1 % or more and preferably 0.2 % or more. Since Cr is expensive, adding more than 1.0 % of Cr causes a significant increase in cost. Accordingly, in the case where Cr is contained, the C content is 1.0 % or less, preferably 0.5 % or less, and more preferably 0.2 % or less.

### Sb: 0.003 % to 0.03 %

Sb is an element that has the effect of suppressing decarburization of the surface layer of the steel sheet during the annealing process when producing the base steel sheet. In order to achieve this effect, in the case where Sb is contained, the Sb content is 0.003 % or more and preferably 0.005 % or more. If the Sb content is more than 0.03 %, the rolling load increases, as a result of which productivity decreases. Accordingly, in the case where Sb is contained, the Sb content is 0.03 % or less, preferably 0.02 % or less, and more preferably 0.01 % or less.

### [Production method for steel sheet for hot pressing]

The steel sheet for hot pressing according to the present disclosure can be produced by any method without limitation. Preferred production conditions will be described below.

First, a base steel sheet is produced. The base steel sheet can typically be produced by rolling a steel slab obtained by casting. As the steel slab, a steel slab having the above-described chemical composition is preferably used.

In the rolling, a hot slab obtained by casting may be directly hot rolled (without reheating), or a cold slab decreased in temperature after casting may be reheated and hot rolled. A steel sheet obtained by directly rolling a hot slab and a steel sheet obtained by reheating and then rolling a cold slab differ little in properties. In the case of reheating a cold slab before hot rolling, the reheating temperature is not limited, but is preferably in the range of 1000 °C to 1300 °C from the viewpoint of productivity.

The hot rolling may be performed by either a normal hot rolling process or a continuous hot rolling process in which slabs are joined and rolled in finish rolling. The rolling finish temperature in the hot rolling is not limited, but is preferably higher than or equal to Ar3 transformation point from the viewpoint of productivity and sheet thickness accuracy.

The hot-rolled steel sheet obtained by the hot rolling is then cooled according to a conventional method. Here, the coiling temperature is preferably 550 °C or higher from the viewpoint of productivity. If the coiling temperature is excessively high, the pickling property degrades. The coiling temperature is therefore preferably 750 °C or lower. After the cooling, it is preferable to perform pickling according to a conventional method.

In the case of using a cold-rolled steel sheet as the base steel sheet, cold rolling is further preformed according to a conventional method after the pickling.

A coating layer is then formed on the surface of the resultant steel sheet. The method of forming the coating layer is not limited, and may be any method such as coating or plating, physical vapor deposition (PVD), or clad rolling. Examples of the coating or plating include electroplating. Examples of the PVD include vacuum deposition, sputtering, and ion plating. In the case of using clad rolling, a layer having the desired composition is stacked on both sides of the base steel sheet and subjected to rolling.

The method of forming the coating layer is preferably selected depending on the composition of the coating layer to be formed. For example, in the case where the coating layer is a Ni layer, a Ni-Cr alloy layer, or a Ni-Zn alloy layer, the coating layer is preferably formed by electroplating, although the coating layer can also be formed by other methods without problems. In the case where the coating layer has a composition for which electrodeposition from an aqueous solution is difficult, such as a Ni-Ti alloy, the coating layer is preferably formed by PVD.

Regardless of which method is used to form the coating layer, the conditions are adjusted so that each of the coating layer on one side (front side) of the steel sheet and the coating layer on the other side (back side) of the steel sheet will have the desired thickness. For example, in the case of electroplating, the thickness of the coating layer on each side can be adjusted by changing one or both of the current density and the current passage time on the side.

### [Hot-pressed member]

A hot-pressed member in one embodiment of the present disclosure includes: a base steel sheet; and a coating layer of 7 µm to 20 µm in thickness provided on both sides of the base steel sheet, wherein the coating layer is made of Ni or a Ni-based alloy, and the Zn content in the coating layer is 0 % to 10 %.

In another embodiment of the present disclosure, the hot-pressed member further includes an oxide layer of 10 µm or less in thickness on the coating layer. In detail, the hot-pressed member in this embodiment includes: a base steel sheet; a coating layer of 7 µm to 20 µm in thickness provided on both sides of the base steel sheet; and an oxide layer of 10 µm or less in thickness provided on the coating layer, wherein the coating layer is made of Ni or a Ni-based alloy, and the Zn content in the coating layer is 0 % to 10 %.

For the base steel sheet and the coating layer, the above description of the base steel sheet and the coating layer in the steel sheet for hot pressing applies.

### [Oxide layer]

The oxide layer is formed as a result of components contained in the coating layer or base steel sheet reacting with oxygen or water vapor in the atmosphere during the hot pressing process. The composition and thickness of the oxide layer vary depending on heating conditions such as heating temperature, heating time, and atmosphere. If the thickness of the oxide layer is more than 10 µm, painting layer adhesion decreases, making it impossible to obtain sufficient post-painting corrosion resistance. Accordingly, in the case where the oxide layer is present, the thickness of the oxide layer is 10 µm or less, preferably 7 µm or less, and more preferably 5 µm or less.

Since the oxide layer is not essential, the lower limit of its thickness may be 0 µm. However, providing a thin oxide layer on the coating layer can enhance painting layer adhesion and further improve post-painting corrosion resistance. Hence, from the viewpoint of further improving post-painting corrosion resistance, the thickness of the oxide layer is preferably 0.1 µm or more, more preferably 1 µm or more, and further preferably 2 µm or more.

The formed oxide layer may be removed by performing shot blasting after hot pressing. The removal of the oxide layer is, however, not essential because it causes an increase in production cost.

The thickness of the oxide layer can be measured by observing a cross section of the hot-pressed member using a scanning electron microscope (SEM). More specifically, the thickness of the oxide layer can be measured by the method described in the EXAMPLES section.

Although the composition of the oxide layer is not limited, we found that higher corrosion resistance can be achieved in the case where the fraction of Ni in the metal elements in the oxide layer is 50 at% (atomic percent) or more. The reason for this is presumed to be as follows: The oxide layer is formed as a result of components contained in the coating layer or the base steel sheet being oxidized during the hot pressing process, as mentioned above. For example, if the oxide layer is mainly made of oxide of Fe contained in the base steel sheet, the electric resistance of the oxide layer is relatively low. Since Ni oxide has higher electric resistance than other oxides such as Fe oxide, increasing the proportion of Ni oxide contained in the oxide layer can suppress electrochemical corrosion. Hence, from the viewpoint of suppressing electrochemical corrosion and further enhancing corrosion resistance, the fraction of Ni in the metal elements in the oxide layer is preferably 50 at% or more. The upper limit of the fraction of Ni is not limited, and may be 100 at%. From the viewpoint of ease of production, however, the fraction of Ni is preferably 98 at% or less.

The fraction of Ni in the metal elements in the oxide layer can be measured by quantitatively analyzing a cross section of the hot-pressed member using an electron probe microanalyzer (EPMA). More specifically, the fraction of Ni in the metal elements in the oxide layer can be measured by the method described in the EXAMPLES section.

### [Hot-pressed member production method]

In one embodiment of the present disclosure, a coated steel sheet for hot pressing is hot pressed to produce a hot-pressed member. The method of hot pressing is not limited, and hot pressing may be performed according to a conventional method. Typically, a steel sheet for hot pressing is heated to a certain heating temperature (heating process), and then the steel sheet for hot pressing heated in the heating process is hot pressed (hot pressing process). Preferred hot pressing conditions will be described below.

If the heating temperature in the heating process is lower than the Ac3 transformation point of the base steel sheet, the strength of the resultant hot-pressed member is low. The heating temperature is therefore preferably higher than or equal to the Ac3 transformation point of the base steel sheet. The heating temperature is preferably 860 °C or higher. If the heating temperature is higher than 1000 °C, there is a possibility that the paint adhesion of the resultant hot-pressed member degrades as a result of an excessively thick oxide layer being formed through oxidation of the base metal or the coating layer. The heating temperature is therefore preferably 1000 °C or lower, more preferably 960 °C or lower, and further preferably 920 °C or lower. The Ac3 transformation point of the base steel sheet varies depending on the steel composition, and is determined by Formaster testing.

The heating start temperature is not limited, but is typically room temperature.

The time (heating time) required for heating to the heating temperature from the heating start is not limited and may be any period of time. If the heating time is more than 300 seconds, however, the time of exposure to high temperatures is long, causing the oxide layer formed through oxidation of the base metal or the coating layer to be excessively thick. Hence, from the viewpoint of suppressing the decrease in paint adhesion caused by oxides, the heating time is preferably 300 seconds or less, more preferably 270 seconds or less, and further preferably 240 seconds or less. If the heating time is less than 150 seconds, there is a possibility that the coating layer melts excessively during heating and as a result stains the heating device or the mold. Hence, from the viewpoint of further enhancing the effect of preventing staining of the heating device and the mold, the heating time is preferably 150 seconds or more, more preferably 180 seconds or more, and further preferably 210 seconds or more.

Once the heating temperature has been reached, the steel sheet for hot pressing may be held at the heating temperature. In the case of holding the steel sheet for hot pressing at the heating temperature, the holding time is not limited and may be any period of time. If the holding time is more than 300 seconds, however, there is a possibility that the paint adhesion of the resultant hot-pressed member degrades as a result of an excessively thick oxide layer being formed through oxidation of the base metal or the coating layer. The holding time is therefore preferably 300 seconds or less, more preferably 210 seconds or less, and further preferably 120 seconds or less. Since the holding is optional, the holding time may be 0 seconds. From the viewpoint of homogeneously austenitizing the base steel sheet, however, the holding time is preferably 10 seconds or more.

The atmosphere in the heating process is not limited, and the heating may be performed in any atmosphere. For example, the heating may be performed in an air atmosphere, or in an atmosphere into which an air flows. From the viewpoint of reducing the amount of diffusible hydrogen remaining in the hot-pressed member, the dew point of the atmosphere is preferably 10 °C or lower. The lower limit of the dew point is not limited. However, given that, in order to set the dew point to lower than -80 °C, special equipment for preventing the inflow of air from the outside and maintaining the low dew point is needed and a cost increase ensues, the dew point is preferably -80 °C or higher and more preferably -40 °C or higher from the viewpoint of cost.

The method of heating the steel sheet for hot pressing is not limited and may be any method. Examples of the heating method include furnace heating, electrical resistance heating, induction heating, high-frequency heating, and flame heating. As the heating furnace, any heating furnace such as an electric furnace or a gas furnace may be used.

After the heating, hot press working is performed and, simultaneously with or immediately after the working, cooling is performed using a coolant such as water or a mold to produce a hot-pressed member. In the present disclosure, the hot pressing conditions are not limited. For example, pressing may be started at 600 °C to 800 °C, which is a typical hot pressing temperature range. Since the steel sheet for hot pressing according to the present disclosure has no risk of liquid metal embrittlement, it is also possible to perform forming at a higher temperature than in typical hot pressing. The hot pressing start temperature is therefore preferably 600 °C to 1000 °C.

### EXAMPLES

The presently disclosed techniques will be described in more detail below by way of examples.

As a base steel sheet, a cold-rolled steel sheet of 1.4 mm in thickness having a chemical composition containing, in mass%, C: 0.34 %, Si: 0.25 %, Mn: 1.20 %, P: 0.005 %, S: 0.001 %, Al: 0.03 %, N: 0.004 %, Ti: 0.02 %, B: 0.002 %, Cr: 0.18 %, and Sb: 0.008 % with the balance consisting of Fe and inevitable impurities was used. The Ac3 transformation point of the base steel sheet was 783 °C, and the Ar3 transformation point of the base steel sheet was 706 °C.

A coating layer was formed on both sides of the base steel sheet by the method shown in Table 1. Each of the methods used is as follows. For comparison, no coating layer was formed in Comparative Example No. 1.

### (Electroplating)

The formation of the coating layer by electroplating was carried out under the following conditions. In each case, electrolysis was performed using the base steel sheet as a cathode and an iridium oxide-coated titanium sheet as an anode, and the thickness of the coating layer was adjusted by changing the current passage time.
(1) Ni plating
   - Plating solution composition:
      Nickel sulfate hexahydrate 240 g/L
      Boric acid 30 g/L
   - pH: 3.0
   - Temperature: 50 °C
   - Current density: 40 A/dm²
(2) Ni-Fe alloy plating
   - Plating solution composition:
      Nickel sulfate hexahydrate 192 g/L
      Iron sulfate heptahydrate 48 g/L
      Boric acid 30 g/L
   - pH: 3.0
   - Temperature: 50 °C
   - Current density: 40 A/dm²
(3) Ni-Co alloy plating
   - Plating solution composition:
      Nickel sulfate hexahydrate 180 g/L
      Cobalt sulfate heptahydrate 60 g/L
      Boric acid 30 g/L
   - pH: 3.0
   - Temperature: 50 °C
   - Current density: 40 A/dm²
(4) Ni-Mo alloy plating
   - Plating solution composition:
      Nickel sulfate hexahydrate 13 g/L
      Sodium molybdate dihydrate 19 g/L
      Citric acid 88 g/L
   - pH: 3.5
   - Temperature: 25 °C
   - Current density: 10 A/dm²
(5) Ni-W alloy plating
   - Plating solution composition:
      Nickel sulfate hexahydrate 13 g/L
      Sodium tungsten dihydrate 30 g/L
      Citric acid 88 g/L
   - pH: 3.5
   - Temperature: 25 °C
   - Current density: 10 A/dm²
(6) Ni-Zn alloy plating
   - Plating solution composition:
      Nickel sulfate hexahydrate 240 g/L
      Zinc sulfate heptahydrate 20 g/L
   - pH: 2.0
   - Temperature: 50 °C
   - Current density: 40 A/dm²
(7) Ni-Zn alloy plating
   - Plating solution composition:
      Nickel sulfate hexahydrate 240 g/L
      Zinc sulfate heptahydrate 30 g/L
   - pH: 2.0
   - Temperature: 50 °C
   - Current density: 40 A/dm²
(8) Zn plating
   - Plating solution composition:
      Zinc sulfate heptahydrate 240 g/L
   - pH: 2.0
   - Temperature: 50 °C
   - Current density: 40 A/dm²

### (PVD)

The formation of the coating layer by PVD was carried out by ion plating using batch-type radio frequency (RF) excitation ion plating equipment produced by Showa Shinku Co., Ltd. The temperature of the base steel sheet was 400 °C, the pressure was 3 Pa, and the bias voltage was -20 V. The composition of the coating layer was controlled by adjusting the composition of the metal used as the vapor deposition source. The thickness of the coating layer was controlled by adjusting the vapor deposition time.

### (Cad rolling)

A Ni-15.5 % Cr-8 % Fe alloy (Alloy 600) of 300 µm in thickness was stacked on both sides of a steel slab of 30 mm in thickness having the same composition as the base steel sheet, and the resultant steel slab was rolled to produce a steel sheet for hot pressing.

### (Hot-dip coating)

The formation of the coating layer by hot-dip coating was carried out by immersing the base steel sheet in a hot-dip molten bath for 1 second and then performing N₂ gas wiping. The composition of the coating layer was controlled by adjusting the composition of the hot-dip molten bath used.

The chemical composition and thickness of the coating layer in the steel sheet for hot pressing obtained were measured by the following methods. The measurement results are shown in Table 1.

### (Chemical composition of coating layer)

The steel sheet for hot pressing to be evaluated was sheared to collect a 10 mm × 15 mm sample. The sample was embedded in a conductive resin to prepare a cross-sectional sample of the steel sheet for hot pressing. The average composition in the range from the outermost layer of the coating layer to the interface between the coating layer and the base steel sheet was then measured using an electron probe microanalyzer (EPMA). Three samples were measured in this way, and the measured values were averaged to determine the chemical composition of the coating layer.

### (Thickness of coating layer)

The thickness of the coating layer in the steel sheet for hot pressing was measured by observing the cross-sectional sample using a scanning electron microscope (SEM). Specifically, the thickness of the coating layer was measured at any ten locations within an observation field with a width of 100 µm or more. Three samples were measured in this way, and the measured values were averaged to determine the thickness of the coating layer.

Next, the steel sheet for hot pressing was subjected to hot pressing. Specifically, a 100 mm × 200 mm test piece was collected from the steel sheet for hot pressing, and the test piece was heated in a roll-conveyance far infrared heating furnace. The heating was performed under the conditions of heating temperature: 900 °C, heating time: 180 seconds, and holding time: 10 seconds.

The steel sheet for hot pressing was then subjected to hat-shaped hot pressing at 2 spm (strokes per minute) using a pressing device installed adjacent to the heating furnace. The forming start temperature was 750 °C. The shape of the obtained hot-pressed member was as follows: the length of the flat part on the upper surface: 100 mm, the length of the flat part on the side surface: 50 mm, and the length of the flat part on the lower surface: 50 mm. The curvature radius of the mold was 7R for both shoulders on the upper surface and both shoulders on the lower surface.

The hot-pressed member of Example No. 8 was subjected to pneumatic shot blasting to remove the oxide layer. In the shot blasting, the air pressure was 2 kgf/cm², the distance between the nozzle and the hot-pressed member was 20 mm, and steel balls with an average particle size of 0.3 mm were used as shot bullets.

### (Chemical composition and thickness of coating layer)

The chemical composition and thickness of the coating layer in the obtained hot-pressed member were measured. First, the flat part of the top of the hot-pressed member pressed into the hat shape was cut out and further sheared to obtain a 10 mm × 15 mm sample. The sample was then embedded in a conductive resin to prepare a cross-sectional sample of the flat part of the hot-pressed member. Using the cross-sectional sample, the chemical composition and thickness of the coating layer were measured by the same methods as those used for the coating layer in the steel sheet for hot pressing described above. The measurement results are shown in Table 2.

Moreover, the composition and thickness of the oxide layer in the hot-pressed member were measured by the following methods. The measurement results are shown in Table 2.

### (Composition of oxide layer)

The composition of the oxide layer in the hot-pressed member was measured with an EPMA using the cross-sectional sample. Point analysis was performed at any ten points within an observation field with a width of 100 µm or more. In the measured values, the atomic concentration of Ni was divided by the sum of the atomic concentrations of all metal elements to calculate the fraction of Ni in the oxide layer.

### (Thickness of oxide layer)

The thickness of the oxide layer in the hot-pressed member was measured by scanning electron microscope (SEM) observation using the cross-sectional sample. Specifically, the thickness of the oxide layer was measured at any ten locations within an observation field with a width of 100 µm or more, and all of the measured values were averaged to determine the thickness of the oxide layer.

### <Adhesion to conveyance rollers>

In order to evaluate the adhesion of metals and oxides to heating equipment, 60 shots of hot pressing were performed on each steel sheet for hot pressing. After this, the conveyance rollers in the heating furnace used for the hot pressing were cooled to room temperature, and whether there was any substance adhered to the surface of each conveyance roller was visually checked. Based on the proportion (adhered roller ratio) of the rollers to which a substance of 3 mm² or more in size was observed to be adhered to all conveyance rollers in the heating furnace, the adhesion to the conveyance rollers was evaluated in the following four levels. Evaluation results of 1 to 3 were rated as pass. The evaluation results are shown in Table 2.
1: adhered roller ratio = 0 %
2: 0 % < adhered roller ratio ≤ 5 %
3: 5 % < adhered roller ratio ≤ 10 %
4: adhered roller ratio >10 %

### <LME cracking during forming>

In order to evaluate liquid metal embrittlement cracking during hot press forming, cracking in each obtained hot-pressed member was measured. Specifically, first, the shoulder part on the upper surface of the hat-shaped hot-pressed member was cut out, embedded in a resin, and then etched with 3 % nital. A cross section was then observed, and the depth of cracks extending from the surface of the shoulder part to the inside in the thickness direction was measured. For each example, three samples were observed, and LME cracking during forming was evaluated in the following four levels based on the length of the longest crack. Evaluation results of 1 to 3 were rated as pass. The evaluation results are shown in Table 2.
1: maximum crack length = 0 mm
2: 0 mm < maximum crack length ≤ 0.01 mm
3: 0.01 mm < maximum crack length ≤ 0.1 mm
4: maximum crack length > 0.1 mm

### <Post-painting corrosion resistance>

The post-painting corrosion resistance of each obtained hot-pressed member was evaluated according to the following procedure. First, a sample was prepared by performing zinc phosphate chemical conversion treatment and electrodeposition painting (coating) on a test piece cut out from the flat part on the upper surface of the hot-pressed member. The zinc phosphate chemical conversion treatment was performed under standard conditions using PB-SX35 produced by Nihon Parkerizing Co., Ltd. The electrodeposition painting was performed using cationic electrodeposition paint Electron GT100 produced by Kansai Paint Co., Ltd. so that the paint film thickness would be 15 µm. The baking conditions were 170 °C and a holding time of 20 minutes.

The obtained sample was subjected to a corrosion test (SAE-J2334), and the corrosion state after 60 cycles was evaluated. The maximum one-side blistering width from the cross cut was measured, and the post-painting corrosion resistance was evaluated in the following four levels based on the maximum one-side blistering width. Evaluation results of 1 to 3 were rated as pass. The evaluation results are shown in Table 2.
1: maximum one-side blistering width < 1.5 mm
2: 1.5 mm ≤ maximum one-side blistering width < 2.0 mm
3: 2.0 mm ≤ maximum one-side blistering width < 3.0 mm
4: 3.0 mm ≤ maximum one-side blistering width

As can be seen from the results in Tables 1 and 2, for each steel sheet for hot pressing according to the present disclosure, adhesion of metals and oxides to heating equipment was reduced, and liquid metal embrittlement cracking during hot press forming was prevented. Moreover, a hot-pressed member obtained by hot pressing each steel sheet for hot pressing according to the present disclosure had excellent post-painting corrosion resistance.

### [Table 1]

**Table 1**

| No. | Steel sheet for hot pressing | | | | | | | | | | | Remarks |
|---|---|---|---|---|---|---|---|---|---|---|---|---|
| | Coating layer | | | | | | | | | | | |
| | Formation method | Composition (mass%) | | | | | | | | | Thickness (µm) | |
| | | Ni | Ti | Cr | Mn | Fe | Co | Mo | W | Zn | | |
| 1 | - | - | - | - | - | - | - | - | - | - | - | Comparative Example |
| 2 | Electroplating | 100 | 0 | 0 | 0 | 0 | 0 | 0 | 0 | 0 | 1 | Comparative Example |
| 3 | Electroplating | 100 | 0 | 0 | 0 | 0 | 0 | 0 | 0 | 0 | 6 | Comparative Example |
| 4 | Electroplating | 100 | 0 | 0 | 0 | 0 | 0 | 0 | 0 | 0 | 8 | Example |
| 5 | Electroplating | 100 | 0 | 0 | 0 | 0 | 0 | 0 | 0 | 0 | 10 | Example |
| 6 | Electroplating | 100 | 0 | 0 | 0 | 0 | 0 | 0 | 0 | 0 | 14 | Example |
| 7 | Electroplating | 100 | 0 | 0 | 0 | 0 | 0 | 0 | 0 | 0 | 18 | Example |
| 8 | Electroplating | 100 | 0 | 0 | 0 | 0 | 0 | 0 | 0 | 0 | 18 | Example |
| 9 | PVD | 100 | 0 | 0 | 0 | 0 | 0 | 0 | 0 | 0 | 10 | Example |
| 10 | PVD | 80 | 20 | 0 | 0 | 0 | 0 | 0 | 0 | 0 | 10 | Example |
| 11 | PVD | 80 | 0 | 20 | 0 | 0 | 0 | 0 | 0 | 0 | 10 | Example |
| 12 | Clad rolling | 76 | 0 | 16 | 0 | 8 | 0 | 0 | 0 | 0 | 15 | Example |
| 13 | PVD | 80 | 0 | 0 | 20 | 0 | 0 | 0 | 0 | 0 | 10 | Example |
| 14 | Electroplating | 80 | 0 | 0 | 0 | 20 | 0 | 0 | 0 | 0 | 10 | Example |
| 15 | Electroplating | 70 | 0 | 0 | 0 | 30 | 0 | 0 | 0 | 0 | 10 | Example |
| 16 | Electroplating | 60 | 0 | 0 | 0 | 40 | 0 | 0 | 0 | 0 | 10 | Example |
| 17 | Electroplating | 48 | 0 | 0 | 0 | 52 | 0 | 0 | 0 | 0 | 10 | Comparative Example |
| 18 | Electroplating | 80 | 0 | 0 | 0 | 0 | 20 | 0 | 0 | 0 | 10 | Example |
| 19 | Electroplating | 80 | 0 | 0 | 0 | 0 | 0 | 20 | 0 | 0 | 10 | Example |
| 20 | Electroplating | 80 | 0 | 0 | 0 | 0 | 0 | 0 | 20 | 0 | 10 | Example |
| 21 | PVD | 80 | 0 | 10 | 0 | 0 | 10 | 0 | 0 | 0 | 10 | Example |
| 22 | Electroplating | 95 | 0 | 0 | 0 | 0 | 0 | 0 | 0 | 5 | 10 | Example |
| 23 | Electroplating | 90 | 0 | 0 | 0 | 0 | 0 | 0 | 0 | 10 | 10 | Example |
| 24 | Electroplating | 75 | 0 | 0 | 0 | 0 | 0 | 0 | 0 | 25 | 10 | Comparative Example |
| 25 | Hot-dip coating | 0 | 0 | 0 | 0 | 10 | 0 | 0 | 0 | 90 | 10 | Comparative Example |
| 26 | Electroplating | 0 | 0 | 0 | 0 | 0 | 0 | 0 | 0 | 100 | 10 | Comparative Example |
| 27 | Hot-dip coating | Al-10%Si-3%Fe | | | | | | | | | 25 | Comparative Example |
| 28 | Hot-dip coating | Zn-55%Al-1.6%Si | | | | | | | | | 25 | Comparative Example |

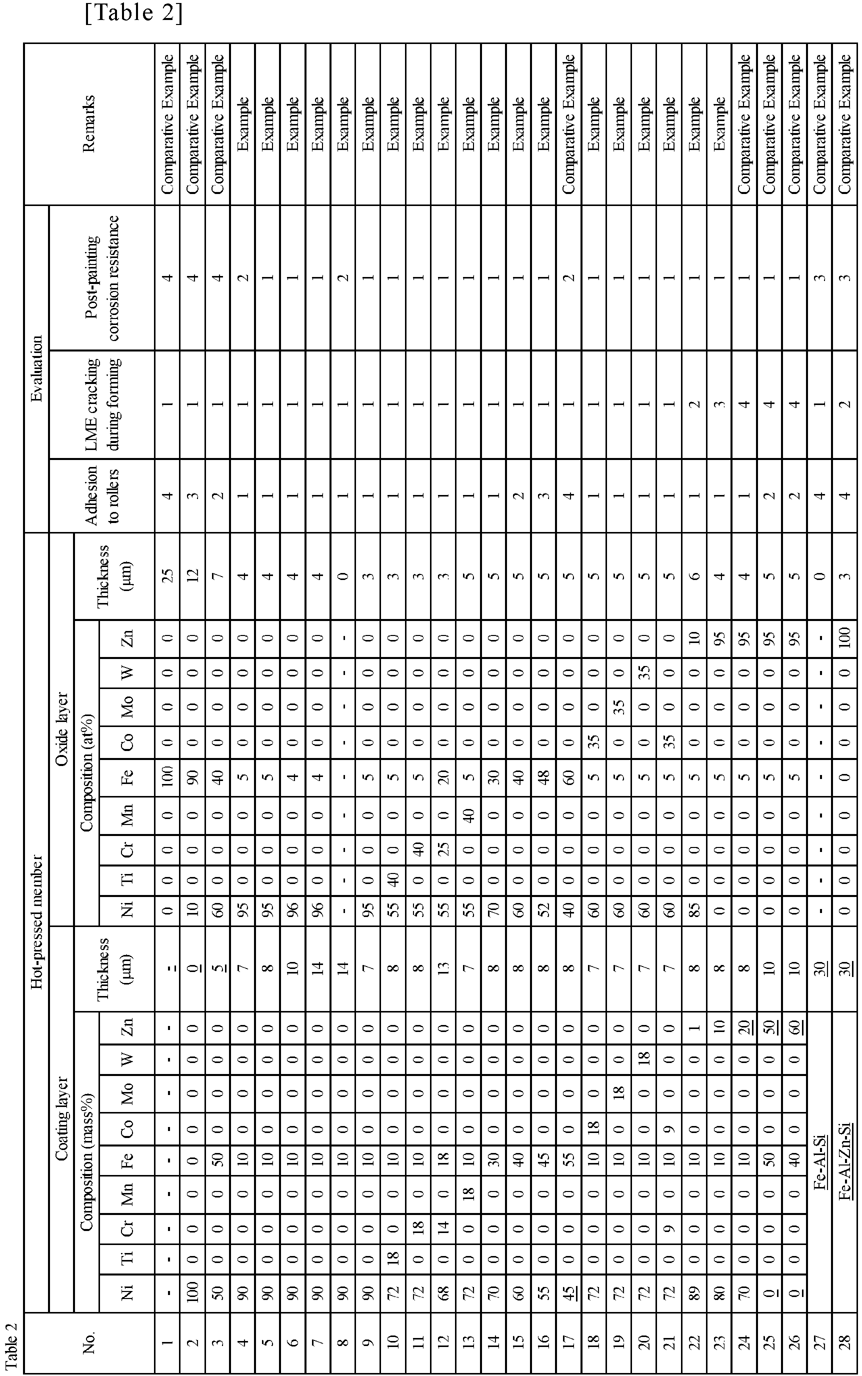

## Claims

1. A steel sheet for hot pressing, comprising:
a base steel sheet; and
a coating layer of 7 µm to 20 µm in thickness provided on both sides of the base steel sheet,
wherein the coating layer is made of Ni or a Ni-based alloy, and a Zn content in the coating layer is 0 mass% to 10 mass%.

2. The steel sheet for hot pressing according to claim 1, wherein the coating layer contains at least one selected from the group consisting of Ti, V, Cr, Mn, Fe, Co, Mo, and W in a total amount of 50 mass% or less.

3. A hot-pressed member comprising:
a base steel sheet; and
a coating layer of 7 µm to 20 µm in thickness provided on both sides of the base steel sheet,
wherein the coating layer is made of Ni or a Ni-based alloy, and a Zn content in the coating layer is 0 mass% to 10 mass%.

4. The hot-pressed member according to claim 3, further comprising an oxide layer of 10 µm or less in thickness on the coating layer.

5. The hot-pressed member according to claim 4, wherein a fraction of Ni in metal elements in the oxide layer is 50 at% or more.

6. A hot-pressed member production method comprising hot pressing the steel sheet for hot pressing according to claim 1 or 2 to obtain a hot-pressed member.
